# EUROPEAN PATENT APPLICATION

(11) **EP 3 893 606 A1**
(43) Date of publication of application: **13.10.2021**
(21) Application number: 19893991.0
(22) Date of filing: 02.12.2019
(51) Int. Cl.: H05B 33/02, H05B 33/04, H05B 33/06, H05B 33/10, H01L 51/50

(54) **DEVICE SEALING METHOD**

(30) Priority: 03.12.2018 JP 2018226938
(71) Applicant: Lan Technical Service Co., Ltd., Shinjuku-ku Tokyo 163-0532 (JP)
(72) Inventor: MATSUMOTO, Yoshiie, Tokyo 163-0532 (JP)
(74) Representative: Michalski Hüttermann & Partner Patentanwälte mbB
(86) International application number: PCT/JP2019/047092
(87) International publication number: WO 2020/116404

(57) **Abstract**

This electronic device sealing method includes: preparing a device substrate that has a cavity for forming a device, an edgeformed higher than the cavity so as to surround the cavity, and an electrode extraction groove at (a portion of) the edge; preparinga cover substrate; forming an electronic device in the cavity of the device substrate; forming in the groove a lead-out wiring led outfrom the electronic device; forming an inorganic material thin film on surfaces of the device substrate and of a cover glass, at leasta surface of the edge of the device substrate and at a portion, of the surface of the cover substrate, to which the edge of the devicesubstrate is joined,; and joining the device substrate and the cover substrate with the inorganic material thin film therebetween.

## Description

### Technical Field

The present disclosure relates to a method of sealing a device.

### Background Art

In the development of optical devices and communication devices, etc., it is becoming important to seal the internal devices with a high sealing degree in the substrate bonding structures for efficiently taking out light from the light emitting element to the outside through the transparent substrate.

For example, an organic EL (electroluminescence) device is formed on a glass substrate or sandwiched between glass substrates, and the sealing is important because it is sensitive to moisture.

For such sealing, methods of using frit glass to prevent entry of moisture from an edge of bonded glass substrates are generally used. The frit material is typically formed by printing on a cover glass surface with a screen printer and fired by heating. The thickness of the frit material is, for example, 20 to 25 µm at the time of printing, but after the glass substrates are bonded, the frit material is heated and shrinks to 6 to 8 µm. This shrinkage creates voids or microcracks due to differences in thermal expansion coefficients from the glass substrate. These defects result in lower tightness.

Also, frit glass is probably week in bonding, and thus an adhesive may be applied to the edge from the outer periphery after bonding. In addition, there is a strong demand for reducing the edge (frame) of a display or the like. However, the printing width of the frit material is about 600 to 800 µm as at the time of filing of the present application. Further narrowing of the frame is required in the future. More specifically, it is desired to be 500 µm or smaller, and further, to be about 100 µm.

Furthermore, sealing with frit glass does not allow the use of thin glass substrates because heat can be applied locally (bonding part at frit material), such as by laser scanning. Thin glass substrates may be distorted by local heating. That is, at present, in many cases, glass substrates having a thickness of about 0.3 mm to 0.5m are used. After such thick glass substrates are bonded, the bonded body is subjected to a hydrofluoric acid treatment for slimming. Nevertheless, there is a high hurdle to make the total thickness to 0.1 mm, and it results in a low yield. In view of the technology and the yield, the thickness of the glass substrates is often about 0.15 mm.

### Summary of Invention

According to one embodiment of the present disclosure, a method of sealing a device is provided. The device is sealed between two bonded substrates. The device is formed on one substrate (device substrate). The cover substrate may have a cavity for forming a digging more than the device height of the device substrate. The cover substrate may have an edge which surrounds the cavity and is formed higher than the cavity. The cover substrate may have a groove to include a part for an electrode extraction of the device substrate at the edge (a part, at least part, or all thereof). The other substrate may have an electrode extraction part. In some embodiments, the sealing method may comprise forming a device on the device substrate, and forming lead wires from the device at positions where the lead wires are embedded in grooves of the cover substrate. In some embodiments, the sealing method may comprise forming an inorganic material thin film on surfaces of the device substrate and the cover glass, at least on a surface of the edge of the device substrate and on a portion of a surface of the cover substrate to which the edge of the device substrate is bonded. In some embodiments, the sealing method may comprise bonding the device substrate and the cover substrate via the inorganic material thin film.

### Brief Description of Drawings

FIG. 1 shows cross-sectional views illustrating steps of a sealing method according to an embodiment.
FIG. 2 shows perspective views of a bonded body formed by a sealing method according to an embodiment.
FIG. 3 shows cross-sectional views illustrating steps of a sealing method according to an embodiment.
FIG. 4 shows a perspective view of a bonded body formed by a sealing method according to an embodiment.

### Description of Embodiments

In some embodiments, a method of sealing an electronic device may be provided. In some embodiments, a method of manufacturing a substrate laminate body including an electronic device may be provided.

In some embodiments, the device substrate may be a glass (substrate). The cover substrate may be a glass (substrate). In some embodiments, the substrate may be transparent. Some substrates may be non-transparent. In some embodiments, the device substrate may be a substrate of Si, SiC, GaN or the like. In some embodiments, the cover substrate may be a substrate of Si, SiC, GaN, or the like. In some embodiments, the device substrate may be a polymeric film. In some embodiments, the cover substrate may be a polymeric film.

In some embodiments, the device substrate may be a transparent substrate. In some embodiments, the cover substrate may be a transparent substrate. A "transparent substrate" refers to a substrate having a high transmittance of light including visible light. For example, the visible light transmittance may be 90% or more. The "transparent substrate" may be a substrate having as a base material or including glass including SiO₂, tempered glass, polymer, or the like.

The substrate to be bonded may be circular or rectangular, or may be in the form of a band (tape).

In some embodiments, a cavity may be configured deep with respect to surrounding structures, such as edges. The depth of the cavity may be greater than or equal to the height or maximum height of the device formed within the cavity. The depth of the cavity may be, for example, between 1 µm and 800 µm, between 1 µm and 600 µm, and between 1 µm and 500 µm.

In some embodiments, the device substrate may not have a cavity. In some embodiments, the device substrate may not have edges. In some embodiments, the device substrate may be flat. In some embodiments, the cover substrate may have a cavity. In some embodiments, the cover substrate may not have a cavity. In some embodiments, the cover substrate may be flat. In some embodiments, both the device substrate and the cover substrate may not have a cavity structure.

In some embodiments, the edge surrounding the cavity may be formed higher than the surface on which the device of the cavity is formed. The height of the edge relative to the cavity bottom may be equal to or greater than the height or maximum height of the device formed in the cavity.

The cover substrate may comprise a groove to include a part for an electrode extraction from the device.

In some embodiments, one substrate may have substantially one single cavity. In some embodiments, one substrate may have at least one cavity. In some embodiments, one substrate may have a plurality of cavities. Each cavity may be defined by or surrounded by an edge.

In some embodiments, the cavity may be formed by etching a surface of the substrate. The etching may be performed using a chemical, physical, physicochemical or other technique, or may be performed using a dry or wet technique, and may be performed by combining a plurality of techniques. In some embodiments, the cavity may be formed by performing etching with hydrofluoric acid on a surface of a glass substrate. The formation of the cavity may be performed by other methods.

In some embodiments, the groove may be formed by etching the edge portion of the glass substrate with hydrofluoric acid. The groove may be formed by other methods. The groove may be formed after the formation of the cavity, the cavity may be formed after the formation of the groove, or the cavity and the groove may be formed at the same timing. In some embodiments, the location of etching of the "cavity" or the "groove" for the electrode extraction may be defined by lithography. For example, a hydrofluoric acid resistant resist may be applied to a glass substrate to form a pattern, and the etching may be performed. In some embodiments, the etching of the "cavity" or the "groove" for the electrode extraction may be performed using a mask made of a metal or another material.

The thickness of the substrate may be equal to or smaller than 1 mm, 700 µm, 500 µm, 300 µm, 200 µm, 100 µm, 75 µm, 50 µm, 40 µm, 30 µm, 20 µm, 10 µm or the like. The thickness of the substrate may be equal to or greater than 10 µm, 20 µm, 30 µm, 40 µm, 50 µm, 75 µm, 100 µm, 200 µm, 300 µm or the like. The thickness of the cover glass may be, for example, between 300 µm and 500 µm, or may be another thickness. The thickness of the device glass may be, for example, between 300 µm and 500 µm, or may be another thickness.

For handling, the substrate to be bonded may be temporarily bonded to another substrate. For example, when the thickness of the bonded substrate is 30 µm, the handling of this substrate is difficult. Therefore, a thin substrate (e.g., 30 µm thick) may be bonded to a relatively thick and handling-capable substrate (e.g., 0.5 mm, 500 µm thick) (support substrate, temporary substrate, etc.) and after the process such as bonding is completed, the support substrate may be removed.

The width of the edge of the device glass may be equal to or smaller than 600 µm, 500 µm, 300 µm, 100 µm or the like.

Devices formed within the cavity may be or include electronic devices, optoelectronic devices, optical devices, chemical devices, biochemical devices, and the like. In some embodiments, the device may be or include a light emitting device. In some embodiments, the device may be or include an electroluminescent (EL) device or an organic EL (OLED) device. The device may substantially consist of one device and may comprise substantially one device. The device may include a plurality of devices. The plurality of devices may include devices of substantially one type or may include a plurality of types of devices.

In some embodiments, the inorganic material thin film may be substantially transparent. When the device is a light-emitting device or element, light emitted from the device can be efficiently emitted to the outside of the bonding body. In some embodiments, the inorganic material thin film may be thin (small in thickness) so that light can be sufficiently transmitted. In some embodiments, the inorganic material thin film may substantially consist of an inorganic material. In some embodiments, the inorganic material thin film may include a member made of an inorganic material. The inorganic material of the inorganic material thin film may be Si (silicon), Al₂O₃ (aluminum oxide), TiO, TiO₂ (titanium oxide), or the like. The compound may be a stoichiometric compound, a compound of a composition deviated from the stoichiometry, and a compound of a non-stoichiometric composition.

The forming of the inorganic material thin film on the bonding surface of the substrate may be performed by a sputter method (sputtering method) by a sputtering method, or may be performed by a method or a process including a sputtering method. The sputtering method may be an ion beam sputtering method or an ion beam assisted sputtering method. It is considered that the metal oxide formed by the ion beam sputtering method has relatively low crystallinity, relatively many crystal defects, relatively many surfaces exposed at atomic level, and so-called dangling bonds. Therefore, it is considered that the surface thereof is in a state of being relatively active and activated, and is easily bonded. However, this physical consideration is an inference, and the present disclosure is not limited to this mechanism.

In some embodiments, the inorganic material thin film may be formed of aluminum oxide (Al₂O₃). In some embodiments, the inorganic material thin film may be titanium oxide (TiO₂). For example, when aluminum oxide (Al₂O₃) is used as an example, forming the inorganic material thin film may include forming aluminum oxide on the object substrate by a sputtering method using metallic aluminum as a target and a mixed gas substantially consisting of an inert gas and oxygen. In another embodiment, the sputtering process may be performed with a mixed gas substantially consisting of nitrogen gas and oxygen, with metallic aluminum as a target. By irradiating a metal target with a mixed gas and sputtering the metal aluminum, a mixture of aluminum and oxygen or an oxide of aluminum, aluminum oxide, can be formed on the bonding surface. Titanium oxide (TiO₂) can also be formed in a similar or another manner.

In another embodiment, forming a thin film of aluminum oxide on the bonding surface of the substrate may include sputtering substantially by inert gas with metallic aluminum as a target, in the direction of the bonding surface, and feeding oxygen gas from another direction to the bonding surface. Titanium oxide (TiO₂) can also be formed in a similar or another manner.

The inert gas may be a rare gas. The rare gas may be any one of helium (He), neon (Ne), argon (Ar), krypton (Kr), xenon (Xe), and radon (Rn), and may be a plurality of mixed gases thereof. The inert gas may be in particular argon (Ar).

A thin film of a metal oxide (e.g., Al₂O₃) can be formed by sputtering a metal (e.g., aluminum) target using a mixed gas of a rare gas such as argon and oxygen gas.

The oxide of aluminum in the thin film may be Al₂O₃ of stoichiometric composition, a non-stoichiometric composition, or a mixture thereof. In the metal oxide formed, the bonding form of aluminum and oxygen may be different from that of Al₂O₃ of the stoichiometric composition, and different ones may be included. The same applies to titanium oxide (TiO₂).

The mixed gas used for sputtering may substantially consist of argon gas and oxygen gas. The flow rate of the oxygen gas contained in the mixed gas may be substantially at 3 %, 4 %, 5 %, 6 %, 7 %, 8 %, 9 %, or 10 %, or any value greater than or equal to or greater than any value thereof, with respect to the flow rate or total flow rate of the mixed gas.

The mixed gas may include another argon gas, and may include a rare gas other than argon gas. When the mixed gas includes a gas different from argon gas, or when the sputtering characteristics are substantially different or remarkably different due to an influence of an apparatus or an environment, an appropriate flow rate of the oxygen gas may be selected. For example, if the sputtering rate of the rare gas is smaller than that in the case where only argon gas is used, the flow rate ratio of oxygen may be smaller than 5%, for example, 4 % or 3 % or smaller. Conversely, for example, if the sputtering rate of the rare gas is larger than that in the case where only argon gas is used, the flow rate ratio of oxygen may be greater than 5 %, for example, 6 % or 7 % or greater.

The thickness of the inorganic material thin film to be formed may be about 0.1 nm to 10 nm, and may be equal to or greater than, or greater than a value of a 0.1 nm, 0.2 nm, 0.3 nm, 0.4 nm, 0.5 nm, 1 nm, 2 nm, 3 nm, 4 nm, 5 nm, 6 nm, 7 nm, 8 nm, or 9 nm. The thickness of the inorganic material thin film to be formed may be 10 nm or smaller, and may be less than or equal to a value of 9 nm, 8 nm, 7 nm, 6 nm, 5 nm, 4 nm, 3 nm, 2 nm, or 1 nm. The thickness of the layer of the inorganic material thin film in the substrate layered body formed by bonding may be about 0.1 nm to 20 nm.

The properties and the film formation condition of the inorganic material thin film may be confirmed or analyzed using surface-analysis methods such as Auger Electron Spectroscopy (AES, Auger Electron Spectroscopy), X-ray Photoelectron Spectroscopy (XPS, X-ray Photo Electron Spectroscopy), Scanning Electron Microscopy (SEM), Transmission Electron Microscopy (TEM), and the like.

In some embodiments, the inorganic material thin film may be formed on at least one of a surface of an edge of a device substrate and a portion of a surface of a cover substrate to which the edge of a the substrate is bonded. In some embodiments, the inorganic material thin film may be formed both on the surface of the edge of the device substrate and on the portion of the surface of the cover substrate to which the edge of the device substrate is bonded. In some embodiments, the inorganic material thin film may be formed at least on both the surface of the edge of the device substrate and the portion of the surface of the cover substrate to which the edge of the device substrate is bonded. In some embodiments, the inorganic material thin film may be formed at least on the surface of the edge of the device substrate. The inorganic material thin film may be formed only on the surface of the edge of the device substrate and may not be formed on the other portions. The inorganic material thin film may be formed on the surface of the edge of the device substrate and at least a portion of the other portion. In some embodiments, an inorganic material thin film may be formed on the device.

In some embodiments, a surface activation treatment may be performed on the surface of the formed inorganic material thin film or the bonding surface. In some embodiments, after the surface activation treatment, the inorganic material thin film or the bonding surface may be exposed to the air and contacted and bonded after the exposure.

In some embodiments, the substrates may be bonded together without performing a surface activation treatment after the formation of the aluminum oxide film.

The energetic particles may be generated by using a particle beam source, such as an ion beam source or a fast atom beam (FAB) source to accelerate ions or neutral atoms of gas particles or atoms used, or a mixture thereof. The irradiation of the energy particles may be performed using a plasma source.

A particle beam source can be used to give predetermined kinetic energy to the particles. A particle beam source operates in vacuo, for example at a pressure of 1×10⁻⁵ Pa or less.

As a neutral atomic beam source, a fast atomic beam source (FAB, Fast Atom Beam) can be used. A fast atom beam source (FAB) typically generates a plasma of gas and applies an electric field to the plasma to extract positive ions of particles ionized from the plasma and pass them through an electron cloud for the neutralization. In this case, for example, in the case of argon (Ar) as a rare gas, the power supplied to the fast atom beam source (FAB) may be set to 1.5 kV (kilovolts), 15 mA (milliamperes), or may be set to a value between 0.1 and 500 W (watts). For example, when a fast atom beam source (FAB) is operated from 100 W (watts) to 200 W (watts) and when irradiated with a fast atom beam of argon (Ar) for about 2 minutes, the oxide, contaminants and the like (surface layer) on the surface to be bonded can be removed to expose a new surface.

As the ion beam source, a cold cathode type ion source can be used.

The ion beam source may be a line type and cold-cathode type ion beam source. A line type particle beam source is a particle beam source having a line-shaped (linear) or elongated particle beam emission aperture from which a particle beam can be emitted in a line-shape (linear). The length of the emission aperture is preferably larger than the diameter of the substrate to which the particle beam is irradiated. If the substrate is not circular, the length of the emission aperture is preferably greater than the maximum dimension in the direction in which the emission aperture extends, of the substrate to be moved relative to the particle beam source.

The particle beam emitted from the line-type particle beam source irradiates a linear region or an elongated region on the substrate at a time during the surface activation treatment. Then, the substrate support is scanned in a direction perpendicular to the direction in which the emission aperture extends while emitting the particle beam from the line-type particle beam source toward the substrate. As a result, the irradiated area of the linear particle beam passes over all parts of the substrate. Once the line-type particle beam source has passed over the substrate, the entire substrate is substantially uniformly irradiated by the particle beam and surface-activated.

The line type particle beam source is suitable for irradiating a surface of a substrate having a relatively large area with a particle beam relatively uniformly. The line type particle beam source can also irradiate the particle beam relatively uniformly corresponding to various shapes of the substrate.

The energy particles may be a mixed gas substantially consisting of a rare gas and an oxygen gas, and may be the same mixed gas and may include other gases. When an energy particle beam is irradiated using only a rare gas without including an oxygen gas, oxygen may be deficient in the metal in the vicinity of the surface of the metal oxide. At this time, the transmittance of light such as visible light may be lowered due to a relative increase in the amount of metal. This is presumably because it is absorbed in this region including a relatively large amount of the metal. Therefore, it is considered that the energy particle beam to irradiate with respect to the bonding surface can include oxygen, so that this oxygen is bonded to the metal oxide surface, thereby avoiding or reducing the deficiency of oxygen. This is believed to make it possible to obtain a sufficient light transmittance of a laminate body of bonded transparent substrates.

The energy particles may be a rare gas and may include a rare gas. The rare gas may be argon and another noble gas. The energy particles may be neutral atoms or ions, and further may be radical species, and yet further may be a group of particles of a mixture thereof.

"Surface activation" means a treatment or process performed on a surface that would not be substantially bonded or joined when contacted without such a treatment or the like, wherein the surfaces after such a treatment or the like are contacted with each other to obtain a desired or substantially effective bonding. A laminate body formed by bonding substrates after the surface activation treatment may or may not be subjected to a heating, a light treatment, or the like, as they are.

Depending on the operating conditions of each plasma or beam source, or the kinetic energy of the particles, the removal rate of the surface layer may vary. Therefore, it is necessary to adjust each condition including the treatment time of the surface activation treatment. For example, by using a surface analyzing method such as Auger electron spectroscopy (AES, Auger Electron Spectroscopy) or X-ray photoelectron spectroscopy (XPS, X-ray Photo Electron Spectroscopy), a time period after which the presence of oxygen or carbon included in the surface layer cannot be confirmed or a longer time period may be employed as the treatment time of the surface activation treatment.

In some embodiments, it may further include irradiating the bonding surface of the substrate with energy particles prior to the formation of the inorganic material thin film. By the irradiation of the energy particles, by activating the bonding surface of the substrate, for example, the bonding strength between the bonding surface and the thin film formed thereon can be increased.

In some embodiments, a pair of substrates (for example, a device substrate and a cover substrate) may be bonded or bonded together via a thin film of inorganic material. A force may be applied to the substrates at the bonding, from an opposite surface or another surface other than the bonding surface of the bonding surface of the substrate when contacting. For example, a force in a direction perpendicular to the bonding surface may be applied from the outside of the substrate. In some embodiments, the pressurization may be performed by applying a force so as to be substantially uniform across the bonding surfaces in contact. In another embodiment, the pressurization may be performed at different timings relative to different faces of the contacted bonding surfaces in contact. The strength of the force during the pressurization may be constant over time or variable. The pressurization may be performed at different timings with respect to the respective portions of the bonding surface. The pressurization may be formed sequentially with respect to the bonding surface, by moving by sliding a pressurizing apparatus with respect to the substrates in contact. The pressurizing apparatus may have a roller-shaped pressurizing section.

In some embodiments, after the aluminum oxide layer is formed on the bonding surfaces on the substrates, the pair of substrates may be brought into contact or bonded to each other, without being subjected to an atmosphere under a vacuum or a low pressure, but in the air. The air may be under the same or different pressures as the ambient air. The air may have the same component as the ambient air and may have different components. The air may be an atmosphere from which partially or substantially all of the suspended particles, such as particles, from the ambient air.

The air may be an atmosphere in which the amount of moisture or vapor is controlled. The air may include moisture and may not substantially include it. The humidity of the atmosphere may be substantially greater than 0 %, and may be a value of 5 %, 10 %, 20 %, 30 %, 40 %, 50 %, 60 % or the like, or greater.

The amount of exposure to the air during the time from the formation of the inorganic material thing film until the bonding of the substrates may be a time of 1 minute, 2 minutes, 5 minutes, 10 minutes, 15 minutes, 20 minutes, 30 minutes, or the like, or longer, or may be a time of 1 day, 12 hours, 10 hours, 6 hours, 3 hours, 2 hours, 60 minutes, 45 minutes, 30 minutes, or the like, or shorter, under the atmospheric pressure.

In some embodiments, the bonding may be performed under vacuum. In some embodiments, the processes from the formation of the inorganic material thin film to the bonding may be performed under vacuum. In some embodiments, the processes from the device formation to the bonding may be performed under vacuum. In some embodiments, the processes from the device formation, the inorganic material thin film formation, the activation of the bonding surface, and to the bonding may be performed without breaking the vacuum. In some embodiments, the bonding may be performed in an inert atmosphere such as nitrogen. By performing the bonding in a vacuum or an inert atmosphere, for example, the sealing atmosphere of the device can be brought into a non-oxidized state or a state of preventing adverse effects on the device.

The sealing method included in the present disclosure may further include heating the laminate body (bonded body) after the bonding or bonding. In some embodiments, at the heating, at least a portion of the bond may be heated. In some embodiments, at the heating, the entire bonded body may be heated. The heating may be performed simultaneously on the entire substrates or the bonded body, or may be performed for each portion of the substrates or the bonded body.

The temperature of the heating may be substantially or approximately equal to or lower than 80°C (80 degrees Celsius, the same hereinafter), 100°C, 200°C, 250°C, 300°C, 350°C, 400°C or the like. The heating temperature may be substantially or approximately 550°C, 500°C, 450°C, 400°C, 350°C, 300°C, 250°C, 200°C, or the like, or lower.

The heating time may be substantially or approximately 5 minutes, 10 minutes, 15 minutes, 30 minutes, 45 minutes, 1 hour, 2 hours, 3 hours, 4 hours, 5 hours, 6 hours, 8 hours, 10 hours, 12 hours, 15 hours, 18 hours, 20 hours, 24 hours, 36 hours, 48 hours, 72 hours, or the like, or longer. The heating time may be substantially or approximately 96 hours, 72 hours, 48 hours, 36 hours, 24 hours, 20 hours, 18 hours, 15 hours, 12 hours, 10 hours, 8 hours, 6 hours, 5 hours, 4 hours, 3 hours, 2 hours, or the like, or longer.

The heating may be performed, for example, at 300°C for 1 hour. The heating may be performed, for example, at 200°C for 1 hour.

The heating may include locally heating at or near the point where both substrates are substantially in contact or bonded. The heating may include heating the bonding surface or its vicinity with a laser. The heating may include providing thermal energy to or near the interface by other techniques.

The atmosphere of the heat treatment may be the air, a nitrogen atmosphere, or a rare gas atmosphere.

In some embodiments, a sealing material or a sealing agent may be applied to the portion of the groove from the outside of the bonded body. In some embodiments, a silane coupling agent may be applied to the portion of the groove from the outside of the bonded body.

### <Example 1>

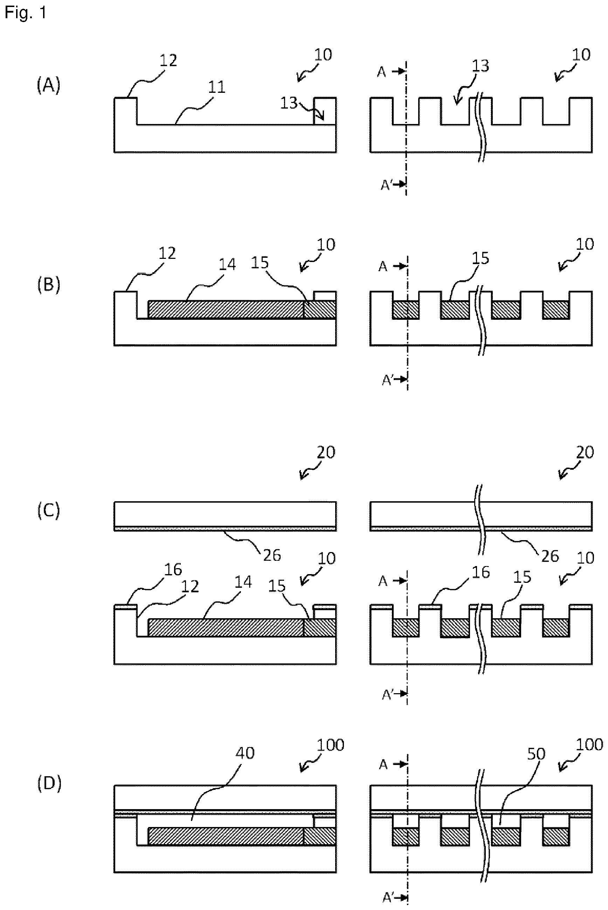

FIGS. 1A to 1D show steps of a method of sealing devices or a method of bonding substrates according to an embodiment. Each figure shows cross-sections perpendicular to the flat plane and perpendicular to each other. The figure on the left shows a cross-sectional view at A-A' of the figure on the right.

FIG. 1A shows a device substrate 10. The device substrate 10 has a device surface 11 on which the device is formed, and the device surface 11 is surrounded by an edge 12. The edge 12 is formed high on the device surface 11, or the device surface 11 is formed deeper than the edge 12. A cover substrate 20 (FIG. 1C, FIG. ID) is bonded at the bonding surface of the edge 12. At that time, the height of the edge 12 with respect to the device surface 11 is set larger than the thickness of the device 14 (FIG. 1B), such that the device 14 (FIG. 1B) is not compressed or contacted to the cover substrate 20 (FIG. 1C).

At a portion of the edge 12 of the device substrate 10, grooves 13 are scribed. The grooves 13 are configured to pass the wires from the outside to the device 14 (FIG. 1B).

In some embodiments, such a structure of the device surface 11 and the groove 13 may be formed by, for example, masking the portion corresponding to the edge 12 and etching other portions of a substrate. The etching may be a wet etching or a dry etching. For example, the etching may be performed by impregnating a pattern-masked glass substrate in a hydrofluoric acid solution. For example, the etching may be a dry etching performed by masking a masked substrate. In some embodiments, a convex portion corresponding to the edge 12 may be bonded to a substrate, and the device surface 11 and the groove 13 may be formed as parts without the edge 12.

As shown in FIG. 1B, the device 14 is formed on the device surface 11 of the device substrate 10. A wiring (electrode lead wire) 15 connected to the outside through the groove 13 from the device 14 is formed.

An inorganic material thin film 16 is applied or formed on the bonding surface of the device surface 12. An inorganic material thin film 26 is applied or formed on the device surface 12 of the cover substrate 20 at a surface portion corresponding to the edge 12 of the device substrate 10 at the bonding.

In FIG. 1C, the inorganic material layers 16,26 are formed on a bonding surface of the edge 12 of the device substrate 10 and on a surface portion of the cover substrate 20 corresponding to the edge 12 of the device substrate 10 at the bonding. The inorganic material layer 16 may be formed, for example, on the device 14 or on the device surface 11 without the device 14 (not shown). The inorganic material layer 16 may have substantially a light transmittance.

In FIG. ID, a device substrate 10 and a cover substrate 20 are bonded at the edge 12, to form a bonded or substrate laminate body 100. In this way, the device 14 is sealed in a sealed space 140 sandwiched between the device substrate 10 and the cover substrate 20.

To bond the device substrate 10 and the cover substrate 20, the height of the lead wire in the groove 13 is lower than the edge 12. Therefore, an opening 50 connecting the sealed space 40 and the outside can be formed in the upper portion of the lead wire 15.

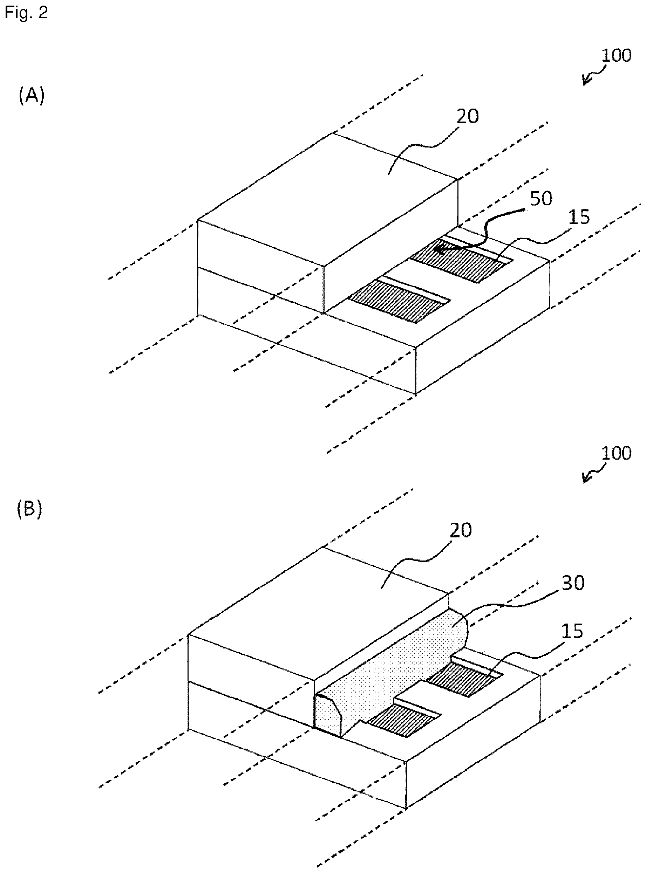

FIG 2A shows a perspective view schematically enlarged vicinity of the electrode lead wires 15 of the bonded body 100 formed by bonding. The device substrate 10 extends from an end of the cover substrate 20. The lead wires 15 are lead out at an end of the cover substrate 20, and are accessible for contacts or the like.

As shown in FIG. 2B, a sealing agent 30 such as a silane coupling agent is applied to the portion of this step. As a result, the opening 50 can be sealed, and the internal space 40 can be sealed from the outside.

According to a method of sealing a device according to an embodiment of the present disclosure, a device substrate surrounds a cavity and has an edge formed higher than the cavity. The edges are free of grooves or the like and can substantially completely or hermetically seal the cavity by bonding with the cover substrate. In some embodiments it may comprise forming an electronic device and an electrode pad in a cavity of the device substrate. In some embodiments, it may comprise forming an inorganic material thin film on a surface of the device substrate and the cover glass, at least on a surface of an edge of the device substrate, and on a portion of a surface of the cover substrate to which the edge of the device substrate is bonded. In some embodiments, it may comprise bonding the device substrate and the cover substrate via a thin film of inorganic material so as to seal the electronic device and the electrode pad.

In some embodiments, openings to the electrode pads may be made from the back surface of the device substrate (an opposite surface of the surface where the device is formed, or another outer surface of the bonded body. Even after the bonding, or after the pad opening, the sealed space is not in contact with the outside air and sealed, from the bonding on. Thus, by way of example, internal devices can be protected from the effects of ambient air. The device is not exposed to the outside air even during use of the device. Thus, for example, the bonding can be performed under vacuum, a nitrogen atmosphere, or other environments that have a relatively low impact on the device relative to the atmospheric environment, thereby sealing its atmosphere. Thus, for example, a long life of the device is expected.

In some embodiments, the opening of the pad may be performed by etching the device substrate. The etching may be a dry etching or a wet etching. The wet etching may be performed using hydrofluoric acid.

### <Example 2>

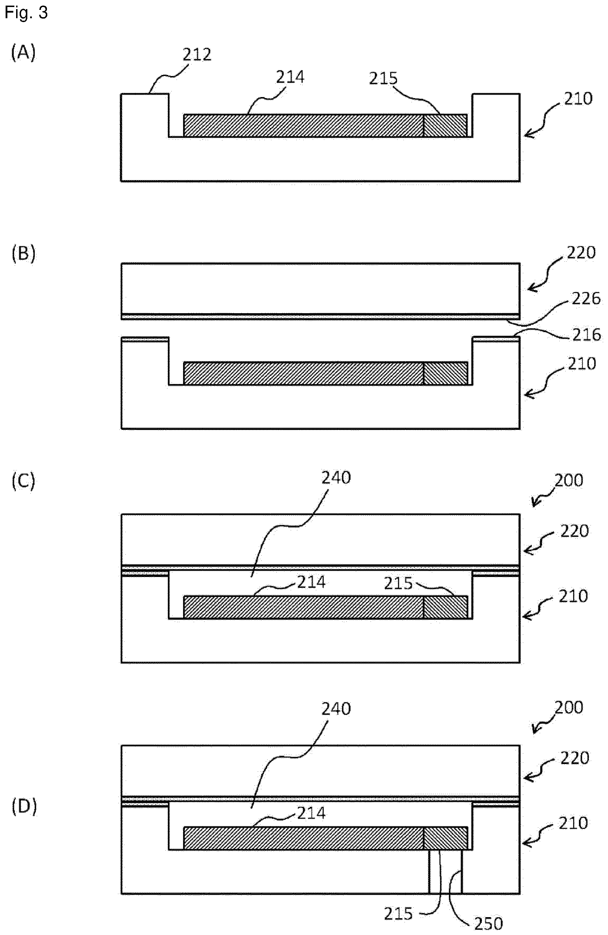

FIGS. 3A to 3D show steps of a method of sealing a device according to an embodiment.

A device substrate 210 is shown in FIG. 3A. The device substrate 210 has a device 214 and a pad electrode 215 formed on a device surface 211 surrounded by an edge 212 and deeper than the bonding surface of the edge 212. The edge 212 of the device substrate 210 has a closed loop structure, and the bonding surface has a flat or planar shape that can be sealingly bonded to the cover substrate. The device substrate 210 and the cover substrate 220 (FIG. 3B to FIG. 3D) can be bonded to substantially seal the internal space.

As shown in FIG. 3B, an inorganic material thin film 216 is formed on the bonding surface of the edge 212 of the device substrate 210, and an inorganic material thin film 226 is formed on the bonding surface of the cover substrate 220.

As shown in FIG. 3C, the device substrate 210 and the cover substrate 220 are bonded to each other via the inorganic material thin films 216,226. The bonded body 200 seals the device 214 and the electrode pad 215 in its internal space 240.

As shown in FIG. 3D, the electrode pads 215 are opened. The device substrate 210 is etched from the outside, to form openings 250. Thus, the electrode pads 215 are accessible from the outside of the bonded body 200. Lead wires may be bonded to the electrode pads 215 through openings 250. Even after the openings 250 are formed, the device 214 and the electrode pad 215 remain sealed in the internal space 240 of the bonded body 200.

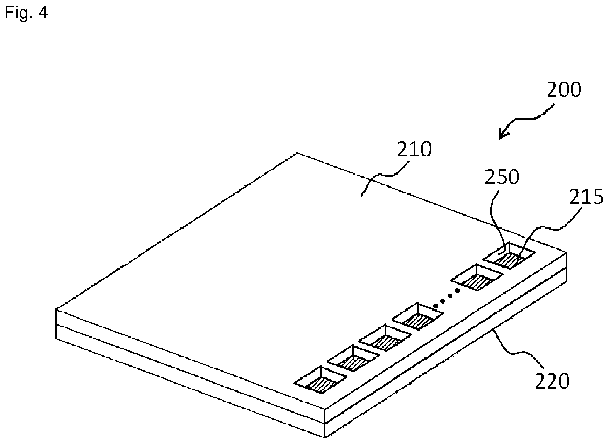

As shown in FIG. 4, the bonded body (substrate laminate body) formed in the steps shown in FIGS. 3A to 3D has a sealing structure in which the devices 214 and the electrode pads 215 (not shown) are sealed between the substrates 210,250. One surface of the electrode pads is externally accessible through the openings 250 in the device substrate 210 and can be connected, such as wires.

The present disclosure also includes electronic or optoelectronic or optical devices, and generally devices, manufactured by a method including any of the substrate bonding methods disclosed in this application. In some embodiments, the device may include a laminate body manufactured in a method comprising a substrate bonding method of any of the present disclosure. In a further embodiment, the device may comprise an organic EL element. In still further embodiments, the device may be a smart phone, a display device, a solar cell, a SAW filter device, or may be a building material such as a window, a pressure-resistant glass, etc.

The present disclosure includes the following embodiments:
A01
   A method of sealing an electronic device, comprising:
   providing a device substrate including:
      a cavity for forming a device;
      an edge surrounding the cavity, and formed higher than the cavity; and
      a groove for electrode extraction formed on at least a portion of the edge;
   providing a cover substrate;
   forming an electronic device in the cavity of the device substrate;
   forming a lead wire from the electronic device in the groove;
   forming an inorganic material thin film on a surface of the device substrate and the cover glass at least on a surface of the edge of the device substrate and on a portion of the surface of the cover substrate to which the edge of the device substrate is to be bonded; and
   bonding the device substrate and the cover substrate via the inorganic material thin film.
A01b
   A method of sealing an electronic device, comprising:
   providing a cover substrate comprising:
      a cavity for forming a digging on the cover substrate more than the height of a device of a device substrate;
      an edge surrounding the cavity and formed higher than the cavity; and
      a groove to include a part for an electrode extraction of the device substrate at (a part of) the edge;
   preparing a device substrate having an electrode extraction portion;
   forming an electronic device on the device substrate, and forming a position where a lead wire is embedded in the groove of the cover substrate;
   forming an inorganic material thin film on a surface of the device substrate and the cover glass, at least on a surface of the edge of the device substrate and on the portion of the surface of the cover substrate to which the edge of the device substrate is to be bonded; and
   bonding the device substrate and the cover substrate via the inorganic material thin film.
A02
   The method of embodiment A01,
   wherein the device comprises a light emitting device.
A03
   The method of embodiment A02,
   wherein the light emitting device includes an organic EL device.
A04
   The method according to any one of embodiments A01 to A03,
   wherein at least one of the device glass and the cover glass is substantially transparent.
A04b
   The method according to any one of embodiments A01 to A03,
   wherein the device substrate is a device glass and the cover substrate is a cover glass.
A05
   The method according to any one of embodiments A01 to A04,
   wherein the inorganic material thin film is substantially transparent.
A06
   The method according to any one of embodiments A01 to A05, further comprising
   activating a surface of the inorganic material thin film prior to bonding the device substrate and the cover substrate.
A07
   The method according to any one of embodiments A01 to A06,
   wherein after said bonding the device substrate and the cover substrate, at least a portion of the bonded body is heated.
A08
   The method of any one of embodiments A01 to A07, further comprising:
   after said bonding the device substrate and the cover substrate, applying a sealing material to the groove portion from the outside of the bonded body.
B01
   A method of sealing an electronic device, comprising:
   providing a device substrate having a cavity for a device formation and an edge surrounding the cavity and formed higher than the cavity;
   providing a cover substrate;
   forming an electronic device and an electrode pad in the cavity of the device substrate;
   forming an inorganic material thin film on a surface of the device substrate and the cover glass, at least on a surface of the edge of the device substrate and on a portion of a surface of the cover substrate to which the edge of the device substrate is bonded; and
   bonding the device substrate and the cover substrate via a thin film of inorganic material so as to seal the electronic device and the electrode pad.
B01b
   A method of sealing an electronic device, comprising:
   providing a cover substrate comprising:
      a cavity for forming a digging on the cover substrate more than the height of a device of a device substrate;
      an edge surrounding the cavity and formed higher than the cavity, and a groove;
   providing a device substrate;
   forming an electronic device and an electrode pad in the device substrate;
   forming an inorganic material thin film on a surface of the device substrate and the cover glass at least on a surface of the edge of the device substrate and on a portion of the surface of the cover substrate to which the edge of the device substrate is to be bonded; and
   bonding the device substrate and the cover substrate via the thin film of inorganic material so as to seal the electronic device and the electrode pad.
B02
   The method of embodiment B01, further comprising etching a portion of the device substrate from the back surface to open the electrode pad.

While several embodiments and examples of the present invention have been described above, these embodiments and examples illustrate the present invention. It is intended that the appended claims cover numerous modifications to the embodiments without departing from the spirit and scope of the invention. Accordingly, the embodiments and examples disclosed herein have been shown by way of illustration and should not be considered as limiting the scope of the present invention.

### Reference Signs List

10,210 Device substrate
11 Device surface
12,212 Edge
13 Groove
14,214 Device
15 Wiring (Electrode lead wire)
16,26,216,226 Inorganic material thin film (inorganic material layer)
20,220 Cover substrate
30 Sealing agent
40,240 Sealed space (internal space)
50,250 Opening
100,200 Substrate laminate body (bonded body)
215 Electrode pad

## Claims

1. A method of sealing an electronic device, comprising:
providing a device substrate including:
a cavity for forming a device;
an edge surrounding the cavity, and formed higher than the cavity; and
a groove for electrode extraction formed on at least a portion of the edge;
providing a cover substrate;
forming an electronic device in the cavity of the device substrate;
forming a lead wire from the electronic device in the groove;
forming an inorganic material thin film on a surface of the device substrate and the cover substrate at least on a surface of the edge of the device substrate and on a portion of the surface of the cover substrate to which the edge of the device substrate is to be bonded; and
bonding the device substrate and the cover substrate via the inorganic material thin film.

2. The method according to Claim 1,
wherein the device comprises a light emitting device.

3. The method according to Claim 2,
wherein the light emitting device includes an organic EL device.

4. The method according to any one of Claims 1 to 3,
wherein at least one of the device substrate and the cover substrate is substantially transparent.

5. The method according to any one of Claims 1 to 4,
wherein the inorganic material thin film is substantially transparent.

6. The method according to any one of Claims 1 to 5,
activating a surface of the inorganic material thin film prior to said bonding the device substrate and the cover substrate.

7. The method according to any one of Claims 1 to 6,
wherein after said bonding the device substrate and the cover substrate, at least a portion of the bonded body is heated.

8. The method according to any one of Claims 1 to 7, further comprising:
after said bonding the device substrate and the cover substrate, applying a sealing material to the groove portion from the outside of the bonded body.

9. A method of sealing an electronic device, comprising:
providing a device substrate having a cavity for a device formation and an edge surrounding the cavity and formed higher than the cavity;
providing a cover substrate;
forming an electronic device and an electrode pad in the cavity of the device substrate;
forming an inorganic material thin film on a surface of the device substrate and the cover glass, at least on a surface of the edge of the device substrate and on a portion of a surface of the cover substrate to which the edge of the device substrate is bonded; and
bonding the device substrate and the cover substrate via the thin film of inorganic material so as to seal the electronic device and the electrode pad.

10. The method according to Claim 9, further comprising:
etching a portion of the device substrate from a back surface to open the electrode pad.
